(19)

Europäisches
Patentamt
European
Patent Office
Office européen
des brevets

(11) **EP 4 224 707 A1**

(12) **EUROPEAN PATENT APPLICATION**

(43) Date of publication:
**09.08.2023 Bulletin 2023/32**

(51) International Patent Classification (IPC):
***H02S 50/00*** *(2014.01)*

(21) Application number: **22305127.7**

(52) Cooperative Patent Classification (CPC):
**H02S 50/00**

(22) Date of filing: **04.02.2022**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **TotalEnergies OneTech**
**92400 Courbevoie (FR)**

(72) Inventors:
- XIE, Peigen
  **91300 MASSY (FR)**
- GOURVENEC, Sébastien
  **91410 ROINVILLE (FR)**
- POULAIN, Gilles
  **92160 ANTONY (FR)**
- AID, Sara
  **75019 PARIS (FR)**

(74) Representative: **Plasseraud IP**
**66, rue de la Chaussée d'Antin**
**75440 Paris Cedex 09 (FR)**

(54) **A METHOD AND COMPUTING DEVICE FOR MONITORING PERFORMANCE OF A PHOTOVOLTAIC PANEL**

(57)     A computer-implemented method for monitoring the performance of a solar panel, the method comprising:
- for a plurality of timepoints among a time period:
o acquiring at least one performance value measurement of the solar panel and values of a set of physical parameters relative to operation of the panel at the corresponding timepoint,
o determining, by application of a trained model to the acquired values the set of physical parameters at a given timepoint, a simulated average performance value of a solar panel, and

- comparing an actual performance of the panel with a simulated average performance over the time period, and
- inferring from said comparison an operational state of the solar panel.

**Fig. 3**

EP 4 224 707 A1

**Description**

TECHNICAL FIELD

The disclosure relates to a computer-implemented method and computing system for monitoring the performance of a photovoltaic panel, based on solar irradiation and ambient temperature. A particular application can be found in the detection of long-term degradations such as soiling or UV-caused degradation. Another application can be found in remote surveillance of the maintenance of a photovoltaic panel.

TECHNICAL BACKGROUND

Photovoltaics panels' actual performance is under influence of many factors, and the various factors do not affect performance in the same way. One can in particular categorize the variations of performance of the panels in three categories:

- Short-term variations (time scale of a few minutes to one hour): variations of irradiation, temperature and other weather conditions,
- Seasonality or recurrent events, and
- Long term variations (time scale of days to months) such as panel degradation related for instance to soiling, moisture, environmental degradations (oxygen, UV,...), mechanical stresses on electric contacts, etc.

The multiplicity of factors affecting the performance of photovoltaics panels increases the difficulty of analyzing the cause of performance degradation and programming maintenance operations accordingly. For instance, an anomaly among the installation such as sensor failure or invertor anomaly may be readily detected and the trouble may be resolved immediately. However, long-term degradation may be more difficult to identity because the impact of said degradation may be too weak compared to other variations. Determining the optimal time for maintenance of panels regarding said long-term degradation is also rendered difficult.

There is therefore a need to be able to separate long-term variations of performance from short-term variations. To this end, it has been disclosed in the publication by Dassler D., Malick S. et al: "Innovative Approach for Yield Evaluation of 6 PV Systems Utilizing Machine Learning Methods. Solar Energy. 2016" an approach for evaluating a yield ratio, being a ratio of daily production versus irradiation, based on supervised learning of an artificial neural network which input data is weather data. The yield ratio depends on a soiling state of the panel and hence computation of the yield ratio is used as an indicator of the soiling state of the panel.

A drawback of this method is that it does not take into account the effect of temperature, as cell temperature of photovoltaic panels affects their optimal performance. Thus, a yield ratio value estimated by the neural network cannot provide sufficient certainty on the soiling state of the panel.

It is also known from Shapsough S., Dhaouadi RI, et al: "Power Prediction via Module Temperature for Solar Modules Under Soiling Conditions, Spring, 2020" a method for estimating the performance of a soiled photovoltaic panel from data including a temperature difference between a clean and a soiled panel, and an optimal performance of a clean panel. The performance estimation is also performed by a trained neural network.

One drawback of this method is the necessity to rely on a permanently clean photovoltaic panel to gather sufficient data for training the neural network, which implies that someone has access to the panel to clean it every day. Another drawback of the method is that it does not take into account temporality, since a temperature increase, and hence a performance decrease, may result from previous heavy irradiation and production of the module.

SUMMARY

The disclosure aims at improving the situation.

In particular, an aim of the disclosure is to provide a method for monitoring the performance of a photovoltaic panel that enables discriminating between short-term and long-term perturbations.

Another aim of the disclosure is to provide a method that is widely applicable.

To this end, a computer-implemented method for monitoring the performance of a solar panel is disclosed, comprising:

- for a plurality of timepoints among a time period:

  ○ acquiring at least one performance value measurement of the solar panel and values of a set of physical parameters relative to operation of the panel at the corresponding timepoint,
  ○ determining, by application of a trained model to the acquired values the set of physical parameters at a given timepoint, a simulated average performance value of a solar panel, and

- comparing an actual performance of the panel with a simulated average performance over the time period, and
- inferring from said comparison an operational state of the solar panel.

In embodiments, inferring an operational state of the solar manel comprises detecting a long-term degradation of the solar panel based at least on the fact that the actual performance of the panel remains lower than the simulated average performance for a duration exceeding a predetermined period.

In embodiments, a long-term degradation of the solar panel is further determined when the gap between the simulated average performance and the actual performance increases over successive comparisons performed within said duration.

In embodiments, inferring an operational state of the solar panel comprises detecting that a maintenance intervention or a meteorological event has occurred based on the comparison between the actual performance and the simulated average performance value over a plurality of successive comparisons.

In embodiments, the set of physical parameters relative to operation of the panel at least comprises solar irradiation on the panel and one of ambient temperature and a temperature of the panel.

In embodiments, the set of physical parameters relative to operation of the panel further comprises at least one of the following parameters:

- wind speed,
- atmospheric pressure,
- humidity level,
- air thermal conductivity.

In embodiments, the trained model is obtained by supervised learning on a dataset comprising values of solar panel performance, and values of the parameters of the set of physical parameters, acquired at regular intervals during a period of time of at least one weak, preferably of at least one month.

In embodiments, the method further comprises a preliminary step of training a model configured to estimate a performance value of a photovoltaic panel based on input data comprising values of the set of physical parameters, wherein the training of the model is performed on a dataset comprising values of performance, and values of the set of physical parameters acquired at regular time intervals during a period of time of at least one weak, preferably of at least one month.

In embodiments, the method comprises the training of a plurality of models associated to respective configurations of photovoltaic panels.

In embodiments, the trained model is a recurrent neural network.

In embodiments, the set of physical parameters comprises solar irradiation on the panel and one of ambient temperature and a temperature of the panel, and the trained model is a recurrent neural network configured to compute a temperature factor from values of temperature and solar irradiation, and to predict a performance value of the photovoltaic panel based on solar irradiation and said temperature factor.

In embodiments, the time period is of at least one day, and the comparison comprises computing a cumulative difference between the performance measurement values and the simulated average performance values over one day.

In embodiments, the method further comprises recording, for said at least one day, the values obtained at each acquisition and the corresponding simulated average performance values, and determining (250), by application of a second trained model on said recorded values, whether the corresponding day was subject to an operational perturbation.

In embodiments, the method further comprises a preliminary step of training a second model configured to classify a day of operation between normal operation days and perturbed operation days based on a training dataset comprising, for each of a plurality of days:

- recorded acquisitions at regular time intervals during the day of measured performance value of a photovoltaic panel, solar irradiation on the panel and ambient temperature,
- corresponding simulated performance values and
- a classification of the day as being a normal operation day or perturbed operation day.

In embodiments, the second model is further configured to classify a day of operation between normal operation days, perturbed operation days due to perturbed installation, or perturbed operation days due to perturbed weather.

According to another object, a computer program product is disclosed, comprising code instructions which, when executed by a computing system comprising one or more processors, cause said one or more processors to carry out a method according to the description above.

According to another object, a computer-readable storage medium is disclosed comprising instructions which, when executed by a computing system comprising one or more processors, cause said one or more processors to carry out a method according to the description above.

According to another object, a computing system for the monitoring of a solar panel is disclosed, comprising at least one memory and one or more processors configured to carry out the method disclosed above.

The claimed method relies on the comparison of actual performances of a panel with simulated average performance in order to infer an operational state of the panel and for instance, detect and assess long-term degradation of the performance.

The simulated average performance is a time-averaged performance, for given values of irradiation and temperature, over an observation period which is long enough to cover short-term variability and preferably, which is also long enough to also incorporate long-term phenomena. This simulated average performance is obtained by a trained model, on a training dataset obtained from at least one actual panel which is not maintained in optimal operation conditions, and for which acquisitions are realized at regular time intervals during a period of at least one week and preferably at least one month, to include said variability. Accordingly, the training of the model to match the data over the whole duration brings the model to compute an average and below-optimum performance of the panel. This model is thus long-term degradation free.

In embodiments, the trained model is a recurrent neural network. The fact that the neural network is of recurrent type enables it to have a memory of short-term historic production and hence take into account the impact on irradiation on the panel's temperature and hence on its performance.

DESCRIPTION OF THE DRAWINGS

Other features and advantages of the invention will be apparent from the following detailed description given by way of non-limiting example, with reference to the accompanying drawings, in which:

- Figure 1 schematically represents the main steps of a method for monitoring the performance of a solar panel,
- Figure 2 represents for a plurality of days of monitoring, a comparison between actual performance of a panel and simulated average performance over one day,
- Figure 3 represents relative weekly performance of a panel plotted against time and precipitation data,
- Figure 4 represents the validation weekly performance of three different tested models,
- Figure 5 schematically represents a structure of a model trained to output a simulated average performance of a panel.
- Figure 6 schematically represents a computing system for the monitoring of a solar panel.

DETAILED DESCRIPTION OF AT LEAST ONE EMBODIMENT

A method for monitoring the performance of a solar panel will now be detailed with reference to the appended drawings. In embodiments, the method may be applied to photovoltaic (PV) panels, comprising photovoltaic cells which are semiconductors that are designed to produce electricity when exposed to light, due to the photovoltaic effect. In the case of photovoltaic panels, the method may apply either for single-sided photovoltaic panels or dual-sided photovoltaic panels, the later having two opposite main surfaces covered with photovoltaic cells. The method may also apply whether the panels are equipped or not of a solar tracker.

The method may also be applied to thermal solar panels, also known as thermal collectors, which unlike PV panels do not convert solar energy into electricity but absorb the solar energy and couple it to a working fluid such as air or water, which can then be used elsewhere. Thermal solar panels are also subject to long-term degradations such as soiling, which can reduce their performance. The method however does not extend to Concentration Solar Panel, relying on intermediate optics such as mirrors to concentrate the sun light towards a common localization.

The method may also apply to hybrid solar panels, comprising both PV cells and a thermal collector. In such a panel, the thermal collector absorbs the thermal energy captured by the PV cells and transfers that energy to a working fluid, thereby contributing to cooling the PV cells and preventing them from excessive temperature increase.

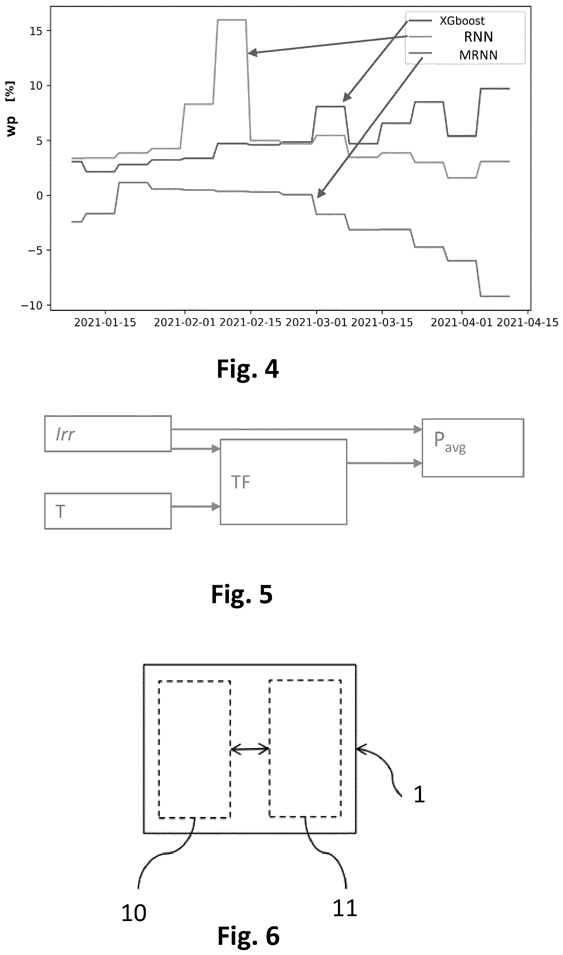

With reference to figure 6, the method described below may be implemented by a computing system 1 comprising one or more processors 10 (which may be collocated or distributed, e.g. in a cloud or high performance computing, HPC, architecture), and a memory 11 (for instance magnetic hard disk, solid-state disk, optical disk, electronic memory or any type of computer-readable storage medium) in which a computer program is stored, in the form of a set of program-code instructions to be executed by the one or more processors in order to implement all or part of the steps of the method detailed below. The memory 11 may also store the trained model used to simulate the average performance of the panel.

The computing system 1 or a distinct computing system may also be used to perform the training of said model. In this case, the computing system further comprises or is connected to a learning database comprising a set of training and validation data.

The method of monitoring the performance of a solar panel disclosed below relies on the comparison of actual performance of the solar panel with a performance reference, i.e. a simulated performance of a panel output by a trained model.

With reference to the prior art documents commented above, the drawback of using irradiation only for solar panel performance monitoring has been mentioned. In order to properly monitor the performance of a solar panel, the performance indicator should also include ambient temperature as input and comprise a mechanism of retrospective. Modelling what a reference solar panel could have produced, given a day's irradiation and ambient temperature, would be resumed in the following equation:

$$P_{ref}(t) = \phi(Irr_{s \leq t}, T_{s \leq t}, t)$$

Where Pref is the performance reference of the solar panel at time t, given past irradiation and ambient temperature up to time t, and provided by a trained model configured to compute the function $\phi$. When the solar panel is a photovoltaic panel, the performance is expressed as an electrical power output by the panel. When the solar panel is a thermal solar panel, the performance corresponds to a quantity of heat produced by the panel, which may be obtained by measuring the temperature of the working fluid. When the solar panel is a hybrid panel, the performance corresponds to the electrical power output by the PV cells of the panel, as the PV cells are the first and most impacted in performance by long-term degradation.

One could contemplate choosing a solar panel's optimal state as a reference because in this condition, the definition of the loss of a panel due to a long-term degradation would be straightforward, as in the following equation:

$$Loss = \int (P_{Opt}(t) - P_r(t))\, dt$$

Where $P_{Opt}$ would correspond to the solar panel's optimal state and $P_r$ corresponds to actual performance measurement, for instance actual electrical power provided by the monitored panel.

However, targeting optimal performance is impractical as one needs a controlled environment to create the model, which means that one needs to clean the panel every day for a prolonged period in order to gather enough data to train the model. A direct consequence is reduced applicability even if one manages to do so.

Hence it is proposed to instead modelize the average state of a solar panel. A similar loss function can be defined in the following equation:

$$Loss = \int (P_{Avg}(t) - P_r(t))\, dt$$

The comparison of an actual panel with the average state of a panel is only offset from the comparison between the actual panel with an optical state by a fixed value given irradiation and temperature as follows:

$$Offset = \int (P_{Opt}(t) - P_{Avg}(t))\, dt$$

Therefore, the average state, due to its accessibility, is a better reference to conduct such comparison.

To establish the performance reference $\phi$ corresponding to an average panel, one would need to train a model computing $\phi$ in order to minimize the following misfit:

$$\left\| P_{Avg}(t) - \phi(Irr_{s \leq t}, T_{s \leq t}, t) \right\|_1$$

However $P_{Avg}$ is unknown, but another task can be designed to predict the actual performance of a solar panel for a prolonged period, by minimizing the misfit defined in the following equation:

$$\left\| P_r(t) - \phi(Irr_{s \leq t}, T_{s \leq t}, t) \right\|_1$$

The model trained to compute the function $\phi$ in

this last case learns to mimic the behavior of the solar panel, while remaining unable to explain the variations whose sources are not included in daily variations. As there is no mechanism of long-term degradation nor seasonality, the minimum of the second misfit defined above is achieved by a value that finds best compromise over the period of training. In other words, the model is forced to converge to an average state over the training period, and this is how the reference performance of the solar panel is defined.

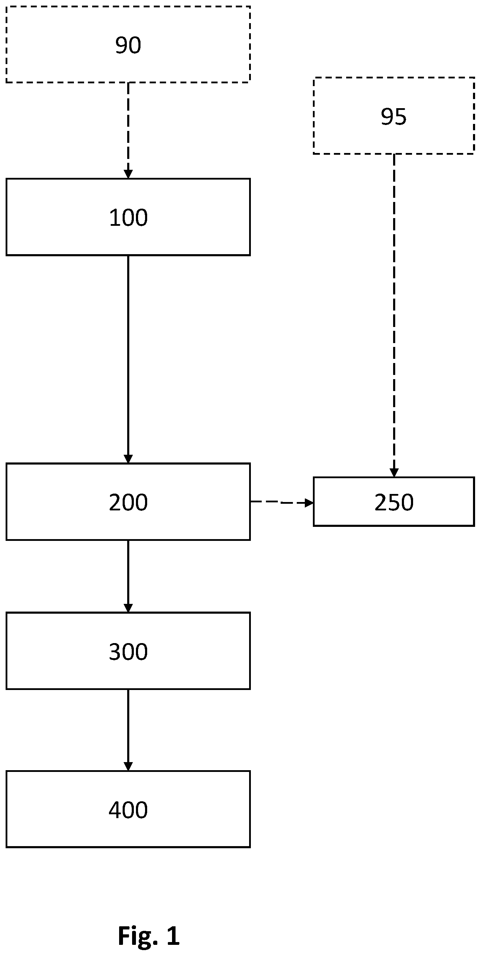

With reference to figure 1, the main steps of a method for monitoring the performance of a panel and shown.

The method comprises acquiring 100, for a plurality of timepoints along a time period, at least one performance value measurement (M(t) where t is a timepoint) of the solar panel to be monitored, along with values of a set of physical parameters relating to operation of the panel, the set of physical parameters comprising at least ambient temperature at the panel or the temperature of the panel or of at least a cell thereof, and solar irradiation on the panel at the corresponding timepoint. In embodiments, the set of physical parameters may further comprise one or more of the following parameters:

- Wind speed,
- A level of air humidity,
- Atmospheric pressure,
- Thermal conductivity of air.

The performance value measurement may for instance be an electrical power produced by the panel when the latter is a PV panel or a hybrid panel. It may be the quantity of heat produced when the panel is a solar thermal panel.

For instance, the acquisition may be performed at regular time intervals over the time period. The time period may be a day, or a period of daylight within a day, and the acquisition may be performed at a frequency of at least one acquisition per hour, preferably several acquisitions per hour, for instance one acquisition every 5 or 10 minutes.

The method also comprises determining 200, by application of a trained model to the acquired values of the set of physical parameters, a simulated average performance value (P(t) where t is a timepoint) of the solar panel. This determination may be performed for each acquisition, i.e. for each of the plurality of timepoints among the time period.

As indicated above, the trained model is configured to compute, from input values comprising values for each parameter of the set of physical parameters, for instance at least values of solar irradiation and ambient or panel temperature, a simulated average performance of a solar panel, i.e. for instance a simulated average electrical power of a photovoltaic panel.

In order to compute an average performance, the model is trained by supervised training on a dataset comprising values of the set of physical parameters (inputs of the models) and corresponding values of performance of a solar panel (e.g. electrical power output), acquired at regular time intervals during a period of time of at least one weak, preferably of at least one month, for instance a period comprised between 1 and 6 months. Thus, the period covered by the training dataset may be long enough to include long-term perturbations such as soiling, and occasional phenomena such as cleaning or rainy events.

The training dataset may comprise for instance at least one acquisition per hour of daylight, or a plurality of acquisitions per hour of daylight, for instance one acquisition every 5 or 10 minutes. The solar panel or panels for which performance values are acquired is/are not maintained in an optimal set. Accordingly, its/their performance varies during the period covered by the dataset due to short-term variations.

Said training may be a preliminary step 90 of the method, for instance implemented by the same, or by a separate computing system 1.

The solar panel which data is acquired may exhibit the same configuration as the solar panel which is then monitored, i.e. either be one-sided or double-sided, have a solar tracker of be devoid of the same, or even be the same make and model as the to-be monitored panel. A plurality of models corresponding to different configurations of solar panels may be trained.

As the model is trained to mimic the behavior of the panel over the whole period, it is thus forced to converge towards an average state which is a compromise over various operational states of the panel over the period.

The trained model may be an artificial neural network, and in particular a recurrent neural network RNN, for instance a long short-term memory LSTM neural network. Recurrent neural networks are used for instance in natural language processing to create semantic context, since they take into account time sequences of data. Relying on a RNN thus allows to keep a memory of the short-term historic production of the panel and hence to render the impact of irradiation on temperature and hence on performance.

In embodiments where the set of physical parameters comprise at least solar irradiation and ambient temperature of panel temperature, with reference to figure 5, the trained model may be a recurrent neural network configured to compute, from the irradiation Irr and temperature T inputs, a temperature factor TF, and configured to predict the simulated average performance value $P_{avg}$ of the solar panel based on said temperature factor. The temperature factor may for instance be the product of irradiation and temperature. In said architecture, all connections between a layer and the next (shown by arrows in figure 5) are layers of LSTM cells. In this architecture, the temperature is thus reduced to a multiplicative factor while irradiation keeps its full potential.

This structure provides less overfitting on temperature as visible on experimental data provided below.

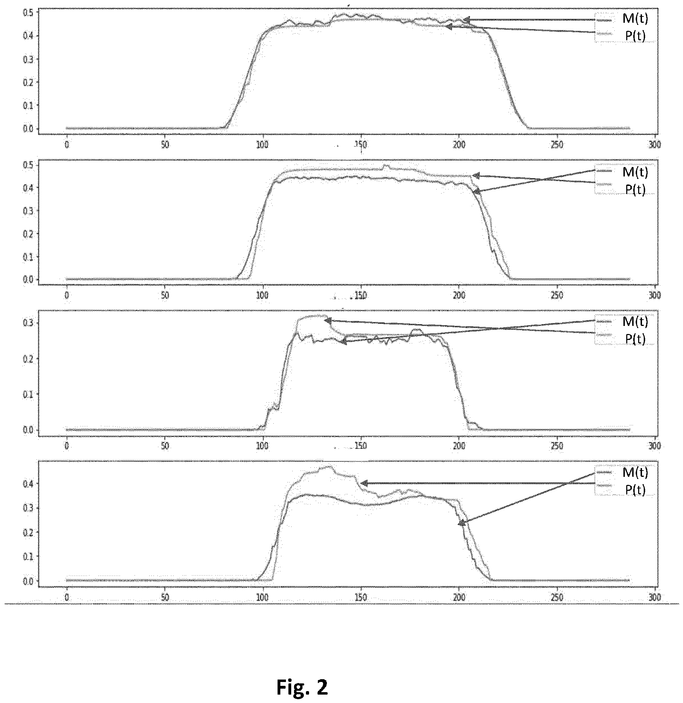

With reference to figure 2 are shown graphs comparing actual performance measurements M(t) and simulated average performance values P(t) of a solar panel for a plurality of days among a period of observations of 6 months, where the first chart from the top represents the compared actual and simulated average data at day 5 of observation, the second chart from the top represents day 44, the third chart from the top represents graph 118 and the bottom chart represents day 179. In this example, the set of physical parameters consists of solar irradiation on the panel and ambient temperature.

One can notice that on day 5 the simulated average performance values fit more closely the actual performance than in the other days, which is indicative of a progressive loss of performance of the monitored panel which can be due to a long-term degradation, for instance to soiling.

Back to figure 1, the method for monitoring the performance of a solar panel further comprises, once performance value measurements and simulated average performances values have been acquired for a plurality of timepoints among a time period, comparing 300 an actual performance of the panel with a simulated average performance over the time period.

As the trained model is configured to output an average performance value of a solar panel, the actual measurement and simulation results are preferably not compared for each time point, but the comparison may comprise computing a cumulative difference between the two, over the time period, said cumulative difference being expressed as follows:

$$loss = \int \left( P_{Avg}(t) - P_r(t) \right) dt$$

The cumulative difference may also be divided by the reference value in order to obtain a difference percentage:

$$loss_\% = \int \frac{\left( P_{Avg}(t) - P_r(t) \right)}{P_{Avg}(t)} dt$$

In embodiments, the time period corresponds to a day and a cumulative difference may be computed for each day. A cumulative difference may also be computed for a week, by computing the averaged cumulative difference over the week.

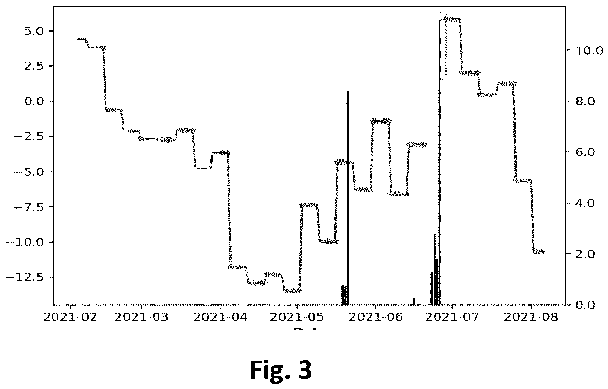

With reference to figure 3 is shown the cumulative difference per week (the cumulative difference is expressed as a percentage, in the left-hand side axis ordinates and the date is represented in abscissa) between performance value measurements and simulated average performance values for a period of six months. One can notice that, due to the trained model outputting an average performance, the performance difference between actual measurements and simulation may be either positive or negative.

Once the comparison is achieved, one can then infer 400 from said comparison an operational state of the solar panel. In particular, one can detect a long-term degradation of the panel, such as soiling or UV-caused degradation, when the actual performance of the panel remains lower than the simulated average performance for a duration exceeding a predetermined threshold. For instance, such degradation may be detected when the actual performance is lower than the simulated average performance for more than one month.

Alternatively, one can also detect a long-term and progressive degradation of the panel when not only the actual performance of the panel remains lower than the simulated average performance for a certain duration, but also when the gap between the simulated average performance and the actual performance increases with time, over the successive comparisons.

Back to figure 3, one can notice that the actual performance of the monitored panel are initially higher than average, and then decrease until becoming lower, with a gap progressively increasing up to -12.5%. A soiling of the panel may be inferred either by a period of more than one month, or even more than two months during which the performance is lower than average, or by the fact that the gap in average increases over a period of two months. Additionally, the days corresponding to rainfall have also been plotted (with the amount of rain being expressed in mm on the right-hand side axis) and it appears that the gap between the actual performance and average simulated performance is reduced, until the actual performance is even restored to being better than average.

The method can thus also allow detecting that a meteorological event such as rainfall, or a maintenance operation, for instance for cleaning the solar panels, has occurred, by detecting an increase in the cumulative difference between measurement values and simulated average values over successive comparisons.

In embodiments, some days may be removed from the computation of the cumulative difference over a week. Indeed, the production of solar panels undergoes many types of perturbations, from operational causes to weather causes. There are also many factors which are not considered in the trained model, such as wind speed, etc. On the other hand, the context created by a RNN prevents the prediction to vary as fast as a sudden event happening. For instance, if the panels are disconnected in the middle of the day, the model cannot cut production immediately. Therefore, the days where such events happen cannot be used for comparison.

Thus all days can be classified, from the actual performance values of the solar panel, as corresponding either to a day of normal operation or to a day of perturbated operation. In embodiments, the classification of the days can be further refined, based on the misfit between actual and simulated performance, such as for instance:

- Normal operation day, during which the actual production is not perturbed and the simulated performance fits normally to the actual performance,
- Unusual performance day, during which the simulated performance fits the actual production but the latter is heavily perturbed; this kind of day can correspond to weather events, and
- Events day, during which the actual performance is perturbed and there is a misfit between the simulation and the actual performance. This kind of day can correspond to operational events related for instance to hardware (failure of a component, etc.).

For comparing 300 the actual performance of the solar panel with a simulated average performance, evaluation of a weekly relative performance may thus take into account only the days corresponding to normal operation days, as follows:

$$wp = 1 - \sum_{week} \left( loss \times 1_{GQ} \right) / \sum_{week} 1_{GQ}$$

Where $1_{GQ}$ equals 1 if the corresponding day is a normal operation day, and 0 otherwise, wp is the weekly relative performance between actual performance and simulated average performance, and *loss* is the cumulative difference defined above, computed for one day. The weekly relative performance may be expressed in percentage by replacing *loss* by $loss_\%$

Furthermore, from this classification of days as being normal operation days or perturbed days, it is also possible to train (step 95 in figure 1) a second model configured to determine, from inputs comprising the performance value measurements acquired for a plurality of timepoints among a time period, for instance a day, and the corresponding simulated average performance values, whether the considered time period was subject to operational perturbation. Such second model can be configured to classify the considered time period into at least two classes comprising normal and anormal period. In embodiments, the second model can also be configured to classify the considered period into at least three classes comprising:

- normal period,
- perturbed period due to perturbed installation, or
- perturbed period due to perturbed weather.

Such second model is trained by supervised learning on a dataset comprising, for a plurality of considered time periods, for instance a plurality of days:

- the performance value measurements acquired for a plurality of timepoints among the time period,

- the corresponding simulated average performance values, and
- a classification of the corresponding time period among one of the previously defined classes.

Said second model may be a decision tree, a random forest, or an artificial neural network. In embodiments, the second model may also be a recurrent neural network, for instance of the LSTM type.

Back to figure 1, the method for monitoring the performance of a solar panel may further comprise, once the performance value measurements are acquired for a given time period and recorded, and the corresponding average performance values are determined for the same time period and recorded, determining 250 by applying the second trained model whether the considered time period was subject to a perturbation or corresponded to a normal period of operation.

*Experimental results*

A real dataset was obtained from a production site of photovoltaic panels in Santiago region, Chile. Two batches of data of six months were available. The first batch started in October 2020 and ended in April 2021, the second batch started in February 2021 and ended in August 2021. The first batch was used for training and validation of the model configured to simulate average performance, and the second batch was used as a blind test set.

For each batch, the acquired data comprised irradiation and ambient temperature as well as actual power of the photovoltaic installation, acquired every 5 minutes over the whole day. A daily log of rain, measured in millimeter, was also available for validation purposes only.

The training set was selected as the data between October 2020 and December 2020, and the validation set comprised the data between January 2021 to April 20201.

For purposes of comparison, a RNN model, a RNN model with modified architecture as represented in Figure 6 and an XGBoosting model where trained. The RNN models were trained on a A100GPU for 500 epochs with a decreasing learning rate each 100 epochs. The XGBoosting model was trained on a CPU. For the performance of RNN, the performance of PV panels was normalized between 0 and 0.5.

The validation metrics of each model are provided in the table below, where one can notice that all three models successfully simulate performance data from irradiation and temperature values:

| Model | MAE | $R^2$ |
|---|---|---|
| XGboost | 0.014 | 0.975 |
| Base RNN | 0.016 | 0.959 |

(continued)

| Model | MAE | $R^2$ |
|---|---|---|
| Modified RNN | 0.013 | 0.973 |

For each trained model, a weekly performance wp according to the definition provided above was computed based on the days of the week corresponding to normal operation days, said weekly performance plotted for the validation period is shown in figure 4.

One can notice that both RNN show a weekly performance which decreases over the observed period, which is an expectable feature due to progressive soiling of the panels. By contrast the XGBoost model does not exhibit such progressive decreases.

Thus, a method has been proposed, based on a model which can consider both irradiation and ambient temperature, and is degradation free. Therefore the deviation from this model can indicate a solar panel's degradation.

**Claims**

1. A computer-implemented method for monitoring the performance of a solar panel, the method comprising:

   - for a plurality of timepoints among a time period:

     ∘ acquiring (100) at least one performance value measurement of the solar panel and values of a set of physical parameters relative to operation of the panel at the corresponding timepoint,
     ∘ determining (200), by application of a trained model to the acquired values the set of physical parameters at a given timepoint, a simulated average performance value of a solar panel, and

   - comparing (300) an actual performance of the panel with a simulated average performance over the time period, and
   - inferring (400) from said comparison an operational state of the solar panel.

2. The method according to claim 1, wherein inferring an operational state of the solar manel comprises detecting a long-term degradation of the solar panel based at least on the fact that the actual performance of the panel remains lower than the simulated average performance for a duration exceeding a predetermined period.

3. The method according to any of the preceding claims, wherein inferring an operational state of the solar panel comprises detecting that a maintenance intervention or a meteorological event has occurred based on the comparison between the actual performance and the simulated average performance value over a plurality of successive comparisons.

4. The method according to any of the preceding claims, wherein the set of physical parameters relative to operation of the panel at least comprises solar irradiation on the panel and one of ambient temperature and a temperature of the panel.

5. The method according to the preceding claim, wherein the set of physical parameters relative to operation of the panel further comprises at least one of the following parameters:

    - wind speed,
    - atmospheric pressure,
    - humidity level,
    - air thermal conductivity.

6. The method according to any of the preceding claims, wherein the trained model is obtained by supervised learning on a dataset comprising values of solar panel performance, and values of the parameters of the set of physical parameters, acquired at regular intervals during a period of time of at least one weak, preferably of at least one month.

7. The method according to any of the preceding claims, further comprising a preliminary step (90) of training a model configured to estimate a performance value of a photovoltaic panel based on input data comprising values of the set of physical parameters, wherein the training of the model is performed on a dataset comprising values of performance, and values of the set of physical parameters acquired at regular time intervals during a period of time of at least one weak, preferably of at least one month.

8. The method according to any of the preceding claims, wherein the trained model is a recurrent neural network.

9. The method according to the preceding claim, wherein the set of physical parameters comprises solar irradiation on the panel and one of ambient temperature and a temperature of the panel, and the trained model is a recurrent neural network configured to compute a temperature factor from values of temperature and solar irradiation, and to predict a performance value of the photovoltaic panel based on solar irradiation and said temperature factor.

10. The method according to any of the preceding claims, wherein the time period is of at least one day, and the comparison comprises computing a cumulative difference between the performance measurement values and the simulated average performance values over one day.

11. The method according to claim 10, further comprising recording, for said at least one day, the values obtained at each acquisition and the corresponding simulated average performance values, and determining (250), by application of a second trained model on said recorded values, whether the corresponding day was subject to an operational perturbation.

12. The method according to claim 11, further comprising a preliminary step (95) of training a second model configured to classify a day of operation between normal operation days and perturbed operation days based on a training dataset comprising, for each of a plurality of days:

    - recorded acquisitions at regular time intervals during the day of measured performance value of a photovoltaic panel, solar irradiation on the panel and ambient temperature,
    - corresponding simulated performance values and
    - a classification of the day as being a normal operation day or perturbed operation day.

13. A computer program product comprising code instructions which, when executed by a computing system comprising one or more processors, cause said one or more processors to carry out a method according to any of the preceding claims.

14. A Computer-readable storage medium comprising instructions which, when executed by a computing system comprising one or more processors, cause said one or more processors to carry out a method as claimed in any of claims 1 to 12.

15. A computing system (1) for the monitoring of a photovoltaic panel, comprising at least one memory (11) and one or more processors (10) configured to carry out the method according to any of claims 1 to 12.

**Fig. 1**

**Fig. 2**

**Fig. 3**

**Fig. 4**

**Fig. 5**

**Fig. 6**

Europäisches
Patentamt

European
Patent Office

Office européen
des brevets

# EUROPEAN SEARCH REPORT

**Application Number**

EP 22 30 5127

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 939 485 B1 (JOHNSON JAY [US] ET AL) 10 April 2018 (2018-04-10) * column 3, line 6 – column 10, line 37; claims 1,6; figures 1-4 * | 1-15 | INV. H02S50/00 |
| X | US 2020/358396 A1 (RAO SUNIL SRINIVASA MANJANBAIL [US] ET AL) 12 November 2020 (2020-11-12) * paragraphs [0030] – [0057]; claims 1-7; figures 3,4,7 * | 1-15 | |

**TECHNICAL FIELDS SEARCHED (IPC)**

H02S

The present search report has been drawn up for all claims

| Place of search | Date of completion of the search | Examiner |
|---|---|---|
| The Hague | 22 June 2022 | Boero, Mauro |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 22 30 5127**

This annex lists the patent family members relating to the patent documents cited in the above-mentioned European search report.
The members are as contained in the European Patent Office EDP file on
The European Patent Office is in no way liable for these particulars which are merely given for the purpose of information.

**22-06-2022**

| Patent document cited in search report | | Publication date | Patent family member(s) | Publication date |
|---|---|---|---|---|
| US 9939485 | B1 | 10-04-2018 | NONE | |
| US 2020358396 | A1 | 12-11-2020 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **DASSLER D. ; MALICK S. et al.** Innovative Approach for Yield Evaluation of 6 PV Systems Utilizing Machine Learning Methods. *Solar Energy,* 2016

- **SHAPSOUGH S. ; DHAOUADI RI et al.** *Power Prediction via Module Temperature for Solar Modules Under Soiling Conditions,* 2020